# EUROPÄISCHE PATENTSCHRIFT

(11) **EP 3 485 313 B1**
(45) Veröffentlichungstag und Bekanntmachung des Hinweises auf die Patenterteilung: **22.05.2024**
(21) Anmeldenummer: 17740658.4
(22) Anmeldetag: 05.07.2017
(51) Int. Cl.: G03F 7/00, G01D 5/24, G02B 19/00, G02B 26/08

(54) **SENSOR-EINRICHTUNG**
SENSOR DEVICE
SYSTÈME CAPTEUR

(30) Priorität: 18.07.2016 DE 102016213026
(43) Veröffentlichungstag der Anmeldung: 22.05.2019
(73) Patentinhaber: Carl Zeiss SMT GmbH, 73447 Oberkochen (DE)
(72) Erfinder: AMELING, Ralf, 73434 Aalen (DE); HAUF, Markus, 89075 Ulm (DE)
(74) Vertreter: Rau, Schneck & Hübner Patentanwälte Rechtsanwälte PartGmbB
(86) Internationale Anmeldenummer: PCT/EP2017/066785
(87) Internationale Veröffentlichungsnummer: WO 2018/015155

(56) Entgegenhaltungen:
- EP-A1- 1 757 972
- EP-A2- 1 180 493
- WO-A1-01/92939
- WO-A2-2009/005160
- DE-A1-102013 201 506
- FR-A1- 2 865 201
- JP-A- 2004 354 108
- US-A1- 2002 008 922
- US-A1- 2006 033 389

## Beschreibung

Die vorliegende Patentanmeldung nimmt die Priorität der deutschen Patentanmeldung DE 10 2016 213 026.9 in Anspruch.

Die Erfindung betrifft eine Sensor-Einrichtung, insbesondere zur Erfassung einer Verlagerungsposition eines optischen Bauelements. Die Erfindung betrifft außerdem ein optisches Bauelement mit einer derartigen Sensor-Einrichtung und eine Vielspiegel-Anordnung mit einer Vielzahl derartiger optischer Bauelemente. Außerdem betrifft die Erfindung eine Beleuchtungsoptik und ein Beleuchtungssystem für eine Projektionsbelichtungsanlage sowie eine Projektionsbelichtungsanlage für die Mikrolithographie. Schließlich betrifft die Erfindung ein Verfahren zur Herstellung eines mikro- oder nanostrukturierten Bauelements sowie ein verfahrensgemäß hergestelltes Bauelement.

Aus der DE 10 2015 204 874 A1 ist ein Spiegel-Array mit einer Vielzahl von verlagerbaren Einzelspiegeln bekannt. Dieses Spiegel-Array umfasst insbesondere Sensor-Einrichtungen zur Erfassung der Verschwenkpositionen der Einzelspiegel.

Aus der FR 2 865 201 A1 ist ein elektrostatischer Aktuator mit vertikal ausgerichteten Kammfingern bekannt.

Es ist eine Aufgabe der vorliegenden Erfindung, eine Sensor-Einrichtung für eine derartige Vielspiegel-Anordnung, ein optisches Bauelement sowie eine entsprechende Vielspiegel-Anordnung zu verbessern.

Diese Aufgaben werden durch eine Sensor-Einrichtung gemäß Anspruch 1 gelöst.

Der Kern der Erfindung besteht darin, mindestens ein Mittel zur Eingrenzung des für die Messung der Verlagerungsposition relevanten elektrischen Feldes auf den Bereich der Statorelektroden, insbesondere auf den Bereich zwischen benachbarten Einzelelektroden der Statorelektroden vorzusehen. Das Mittel dient insbesondere dazu, den Einfluss von inhomogenen Streufeldern in den Randbereich der Statorelektroden, insbesondere in den radialen Randbereichen der Kammfinger der Statorelektroden, auf die Messung der Verlagerungsposition zu minimieren. Hierdurch kann die Sensitivität der Sensor-Einrichtung in Bezug auf lineare Verschiebung und/oder Expansion des optischen Bauelements relativ zu den Statorelektroden, insbesondere aufgrund von einer Wärmeausdehnung des optischen Bauelements und/oder die Sensitivität in Bezug auf Fertigungstoleranzen verringert werden. Die Erfassung der Verlagerungsposition des optischen Bauelements wird dadurch insbesondere robuster, insbesondere weniger störungsanfällig.

Bei den Statorelektroden handelt es sich insbesondere um Kammelektroden. Die Statorelektroden weisen insbesondere jeweils eine Mehrzahl von Kammfingern auf. Die Kammfinger bilden somit jeweils Einzelelektroden der Statorelektroden. Teilweise werden die Kammfinger daher auch selbst als Statorelektroden bezeichnet. Sofern dies nicht zu Unklarheiten führt, wird diese Bezeichnung im Folgenden teilweise ebenfalls übernommen. Der Begriff der Statorelektrode kann somit einerseits die Statorelektrode als Ganzes mit einer Vielzahl von Kammfingem, andererseits auch die einzelnen Kammfinger bezeichnen. Welche dieser Alternativen jeweils gemeint ist, ergibt sich problemlos aus dem jeweiligen Zusammenhang.

Bei der beweglichen Elektrode handelt es sich insbesondere um eine am optischen Bauelement, insbesondere in Form eines Spiegels, angeordnete Kammelektrode.

Beim optischen Bauelement handelt es sich insbesondere um einen Spiegel, insbesondere um einen Mikrospiegel, das heißt einen Spiegel mit einer Kantenlänge im Bereich von Mikrometern, insbesondere mit einer Kantenlänge von weniger als 10 mm, insbesondere weniger als 5 mm, insbesondere weniger als 3 mm, insbesondere weniger als 2 mm, insbesondere weniger als 1 mm. Es kann sich insbesondere um ein sogenanntes mikroelektromechanisches System (MEMS) handeln.

Gemäß einem Aspekt der Erfindung sind die Einzelelektroden der Statorelektroden in einem ringförmigen Bereich angeordnet und erstrecken sich jeweils in einer Ebene durch die Mittelachse dieses Bereichs. Die Statorelektroden erstrecken sich insbesondere in Radialrichtung zur Mittelachse dieses Bereichs. Es handelt sich insbesondere um eine kreisringförmige Kammelektroden-Struktur. Eine derartige Struktur hat sich insbesondere aus geometrischen beziehungsweise mechanischen Gründen als vorteilhaft erwiesen.

Gemäß einem weiteren Aspekt der Erfindung sind die Statorelektroden in mehrere Sektoren aufgeteilt, wobei die Elektroden im selben Sektor eine Sensor-Einheit bilden. Die Elektroden sind insbesondere in vier Quadranten aufgeteilt. Eine hiervon abweichende Aufteilung, insbesondere eine Aufteilung in zwei, drei oder mehr Sektoren, ist ebenso möglich.

Gemäß einem weiteren Aspekt der Erfindung sind die Elektroden in einander bezüglich der Mittelachse des ringförmigen Bereichs gegenüberliegenden Quadranten differenziell verschaltet. Hierdurch kann die Sensitivität gegenüber linearen Störungen, insbesondere in Richtung einer Flächennormalen der Reflexionsfläche des Spiegels, verringert werden. Bezüglich weiterer Vorteile sei auf die DE 10 2015 204 874 A1, deren Inhalt vollumfänglich als Bestandteil der vorliegenden Anmeldung in diese aufgenommen wird, verwiesen.

Die Sensor-Einrichtung umfasst insbesondere differenzielle Sensoren in Form von kapazitiven Kammwandlern, mit welchen über eine Kapazitätsmessung die Relativposition von einem beweglichen Anker zu einem ortsfesten Stator bestimmt werden kann. Hierbei ist insbesondere vorgesehen, die Kapazität zwischen benachbarten Kammfingern der Statorelektroden zu messen, wobei die Finger der beweglichen Elektrode bewegliche Ankerkämme bilden, welche eine variable, positionsabhängige Abschirmung bewirken. Diese Variante wird auch als Abschirm-Modus (Shield Mode) bezeichnet.

Der Abschirm-Modus hat gegenüber einer direkten Messung der Kapazität zwischen Statorkammfinger und beweglichen Kammfinger den Vorteil, relativ unempfindlich gegenüber einer parasitären Bewegung der Kämme relativ zueinander zu sein.

Bei einer differenziellen Verschaltung der Sensoren wird aus der Messung zweier Vertikalbewegungen ein Kippwinkel bestimmt. Gleichtaktbewegungen, welche beispielsweise durch eine durch Thermalausdehnung verursachte Vertikalbewegung des Spiegels verursacht werden, tragen aufgrund der Differenzbildung nicht zum Messsignal des gemessenen Spiegelkippwinkels bei. Die differenzielle Sensoranordnung hat den Vorteil, dass die Kippposition des Spiegels direkt und vollständig über die Sensorpaare erfasst wird. Sie ist insbesondere in erster Näherung nicht auf die Stabilität des mechanischen Drehpunkts, das heißt des effektiven Schwerpunkts, angewiesen.

Gemäß einem weiteren Aspekt der Erfindung umfasst das mindestens eine Mittel zur Eingrenzung des für die Messung der Verlagerungsposition relevanten elektrischen Feldes auf den Bereich zwischen den Statorelektrodenfingern Abschirmelektroden. Die Abschirm-Elektroden werden auch als Guard-Elektroden bezeichnet. Sie dienen insbesondere der Abschirmung elektrischer Streufelder in den Randbereichen der Stator-Elektroden.

Die Abschirmelektroden sind insbesondere jeweils in Verlängerung zu einer der Statorelektroden angeordnet. Sie sind insbesondere jeweils in Radialrichtung außen und/oder innen, das heißt an den Rändern der Statorelektroden, in Verlängerung zu diesen angeordnet. Dies führt zu einer wirksamen Eingrenzung des für die Messung relevanten elektrischen Feldes auf den Bereich zwischen zwei Statorelektroden. Mit Hilfe der Abschirmelektroden ist es insbesondere möglich, den Einfluss von inhomogenen Streufeldern in den Randbereichen der Statorelektroden, insbesondere in den radialen Randbereichen der Kammfinger der Statorelektroden, auf die Messung der Verlagerungsposition zu minimieren.

Gemäß einem weiteren Aspekt der Erfindung weist zumindest eine Teilmenge der Abschirmelektroden einen U-förmigen Querschnitt auf. Es ist insbesondere möglich, sämtliche Abschirmelektroden, insbesondere sämtliche äußere und/oder sämtliche innere Abschirmelektroden, mit einem U-förmigen Querschnitt auszubilden. Hierzu können jeweils zwei benachbarte Abschirmelektroden durch ein Verbindungsstück miteinander verbunden sein. Das Verbindungsstück kann bogenförmig ausgebildet sein. Es kann auch geradlinig ausgebildet sein. In diesem Fall weisen die Abschirmelektroden einen U-förmigen Querschnitt mit drei geradlinigen Schenkeln auf.

Der Winkel zwischen den beiden freien Schenkeln und dem Verbindungsschenkel der in Radialrichtung äußeren Abschirmelektrode ist insbesondere etwas kleiner als 90°. Er liegt insbesondere im Bereich von 80° bis 89°. Der Winkel zwischen den freien Schenkeln und dem Verbindungsschenkel der in Radialrichtung äußeren Abschirmelektrode ist insbesondere gerade halb so groß wie die Differenz von 180° und dem Winkelabstand zweier benachbarter Statorelektroden.

Der Winkel zwischen den beiden freien Schenkeln und dem Verbindungsschenkel der in Radialrichtung inneren Abschirmelektrode ist insbesondere etwas größer als 90°. Er liegt insbesondere im Bereich von 91° bis 100°. Der Winkel zwischen den freien Schenkeln und dem Verbindungsschenkel der in Radialrichtung inneren Abschirmelektrode ist insbesondere gerade halb so groß wie die Summe von 180° und dem Winkelabstand zweier benachbarter Statorelektroden.

Im Falle einer gekrümmten Ausbildung des Verbindungsschenkels kann dieser einen Krümmungsmittelpunkt aufweisen, welcher gerade mit der Mittelachse des ringförmigen Bereichs der Statorelektroden zusammenfällt. In diesem Fall kann der Winkel zwischen den freien Schenkeln und dem Verbindungsschenkel der Abschirmelektroden 90° betragen.

Gemäß einem weiteren Aspekt der Erfindung erstreckt sich die mindestens eine bewegliche Elektrode in Radialrichtung über den gesamten Bereich der Statorelektroden, insbesondere über den gesamten Bereich zwischen zwei benachbarten Kammfingern der Statorelektroden, hinaus bis in den Bereich zwischen zwei in Verlängerung dieser Statorelektroden angeordneten Abschirmelektroden hinein. Die beweglichen Elektroden sind insbesondere jeweils in Radialrichtung innen und außen über den Bereich zwischen den Statorelektroden hinaus verlängert ausgebildet. Hierdurch kann sichergestellt werden, dass sie auch im Falle einer geringfügigen Bewegung in Radialrichtung, insbesondere aufgrund von Störungen, Fertigungstoleranzen oder aufgrund einer Wärmeausdehnung, zumindest in einer Schnittebene senkrecht zur Mittelachse des ringförmigen Bereichs der Statorelektroden, den Bereich zwischen zwei benachbarten Kammfingern der Statorelektroden in Radialrichtung vollständig überdecken. Dies gilt insbesondere für eine Schnittebene im Bereich der dem verlagerbaren optischen Bauelement zugewandten freien Enden der Statorelektroden. Die bewegliche Elektrode wird auch als Spiegelelektrode oder als Sensor-Wandlerspiegel-elektrode bezeichnet.

Die beweglichen Elektroden sind insbesondere derart ausgebildet, dass sich ihr Überlapp mit den Statorelektroden in Radialrichtung bei einer geringfügigen Verschiebung der beweglichen Elektroden relativ zu den Statorelektroden in Radialrichtung nicht verändert.

Hierdurch kann erreicht werden, dass die Sensor-Einrichtung in Bezug auf derartige Relativbewegungen der beweglichen Elektroden zu den Statorelektroden insensitiv ist. Die Sensor-Einrichtung ist insbesondere auch im verkippten Zustand des optischen Bauelements insensitiv auf derartige Relativbewegungen der beweglichen Elektroden zu den Statorelektroden.

Gemäß einem weiteren Aspekt der Erfindung sind die Abschirmelektroden jeweils auf demselben elektrischen Potenzial gehalten wie die mindestens eine bewegliche Elektrode.

Die Abschirmelektroden können auch auf demselben elektrischen Potenzial gehalten werden wie die Statorelektroden.

Die Abschirmelektroden können insbesondere elektrisch leitend mit der mindestens einen beweglichen Elektrode verbunden sein.

Sie können insbesondere untereinander elektrisch leitend miteinander verbunden sein.

Gemäß einem Aspekt der Erfindung ist insbesondere zumindest eine Teilmenge der Abschirmelektroden zu einer ringförmigen Struktur elektrisch leitend miteinander verbunden. Es kann insbesondere vorgesehen sein, sämtliche der inneren Abschirmelektroden und/oder sämtliche der äußeren Abschirmelektroden jeweils zu einer ringförmigen Struktur elektrisch leitend miteinander zu verbinden. Es kann insbesondere vorgesehen sein, sämtliche Abschirmelektroden, welche innerhalb der ringförmigen Struktur der Statorelektroden angeordnet sind, elektrisch leitend miteinander zu verbinden. Es kann insbesondere vorgesehen sein, sämtliche Abschirmelektroden, welche außerhalb der ringförmigen Struktur der Statorelektroden angeordnet sind, elektrisch leitend miteinander zu verbinden. In diesem Fall dienen die Abschirmelektroden insbesondere auch zur Abschirmung von elektrischen Störungen. Auch hierdurch wird die Funktion der Sensor-Einrichtung verbessert.

Ein Vorteil der erfindungsgemäßen Ausbildung und Anordnung der Abschirmelektroden besteht darin, dass diese Lösung zur Verbesserung der Robustheit gegenüber radialen Verschiebungen der beweglichen Elektroden zu den Statorelektroden nur sehr wenig Platz benötigt.

Die Vorteile eines optischen Bauelements mit einer Sensor-Einrichtung gemäß der vorhergehenden Beschreibung ergeben sich aus denen der Sensor-Einrichtung. Bei dem optischen Bauelement handelt es sich insbesondere um einen Spiegel, insbesondere um einen Mikrospiegel, insbesondere um einen MEMS-Spiegel. Es kann sich insbesondere um einen Spiegel mit einer EUV-reflektierenden Beschichtung handeln. Der Spiegel kann insbesondere mindestens zwei Verlagerungsfreiheitsgrade aufweisen. Er kann insbesondere um zwei Kippachsen, insbesondere zwei senkrecht zueinander ausgerichtete Kippachsen, verschwenkbar sein. Der Spiegel kann insbesondere mittels eines Festkörpergelenks gelagert sein. Der Spiegel kann insbesondere mittels einer kardanischen Lagerung gelagert sein.

Die Vorteile einer Vielspiegel-Anordnung, welche auch als Vielspiegel-Array (Multi Mirror Array, MMA) bezeichnet wird, ergeben sich ebenfalls aus denen der Sensor-Einrichtung. Die vorhergehend beschriebene Sensor-Einrichtung führt insbesondere zu einer höheren Präzision und einer geringeren Störanfälligkeit der Verlagerung der Einzelspiegel. Die vorhergehend beschriebene Sensor-Einrichtung weist insbesondere einen sehr geringen zusätzlichen Platzbedarf auf. Dies ist insbesondere bei kleinen Einzelspiegeln, insbesondere sogenannten Mikrospiegeln, von Vorteil. Die Anzahl der Einzelspiegel der Vielspiegel-Anordnung kann insbesondere mindestens 100, insbesondere mindestens 1000, insbesondere mindestens 10000, insbesondere mindestens 100000 betragen. Sie beträgt üblicherweise weniger als 10000000, insbesondere weniger als 1000000.

Weitere Aufgaben der Erfindung bestehen darin, eine Beleuchtungsoptik und ein Beleuchtungssystem für eine Projektionsbelichtungsanlage sowie eine Projektionsbelichtungsanlage für die Mikrolithographie zu verbessern.

Diese Aufgaben werden durch eine Vielspiegel-Anordnung gemäß der vorhergehenden Beschreibung gelöst. Die Vorteile ergeben sich wiederum aus denen der vorhergehend beschriebenen Sensor-Einrichtung.

Eine weitere Aufgabe der Erfindung besteht darin, ein Verfahren zur Herstellung eines mikro- oder nanostrukturierten Bauelements, insbesondere eines Halbleiterchips, sowie ein derartiges Bauelement zu verbessern.

Diese Aufgaben werden durch die Bereitstellung einer vorhergehend beschriebenen Projektionsbelichtungsanlage gelöst.

Die Vorteile ergeben sich wiederum aus denen der Sensor-Einrichtung. Die höhere Präzision und geringere Störungsanfälligkeit der Verlagerung der Einzelspiegel führt insbesondere zu einer höheren Präzision und geringeren Störungsanfälligkeit bei der Belichtung eines Retikels mit abzubildenden Strukturen und damit zu einer höheren Präzision bei der Abbildung dieser Strukturen auf einen zu belichtenden Wafer.

Weitere Vorteile und Einzelheiten der Erfindung ergeben sich aus der Beschreibung von Ausführungsbeispielen anhand der Figuren. Es zeigen:
- Fig. 1: eine schematische Darstellung einer Projektionsbelichtungsanlage und ihrer Bestandteile,
- Fig. 2: eine schematische Darstellung eines optischen Bauelements mit einer Aktuatorund einer Sensoreinrichtung,
- Fig. 3: eine alternative Darstellung des optischen Bauelements gemäß Fig. 2 bei welcher der Spiegelkörper mit den daran angeordneten Gegenelektroden bzw. Abschirm-Elementen zur Seite geklappt ist,
- Fig. 4 bis 6: schematische Darstellungen eines Ausschnitts aus der Sensor-Einrichtung zur Erläuterung der Sensitivität (Fig. 4) bzw. Insensitivität (Fig. 5 und 6) derselben,
- Fig. 7: eine schematische Ansicht zweier benachbarter Sensor-elektroden mit Abschirm-Elektroden und einer dazwischen angeordneten beweglichen Elektrode,
- Fig. 8: schematisch eine Darstellung des elektrischen Feldes im Bereich zwischen den Sensorelektroden zur Erläuterung des Effekts der Abschirm-Elektroden, wobei die bewegliche Elektrode nicht dargestellt ist,
- Fig. 9: eine Darstellung gemäß Fig. 7 mit einer alternativen Ausführung der AbschirmElektroden,
- Fig. 10: eine schematische Aufsicht auf die Statorelektroden mit den AbschirmElektroden gemäß einer weiteren Alternative.

Zunächst wird der allgemeine Aufbau einer Projektionsbelichtungsanlage 1 und deren Bestandteile beschrieben. Für Details diesbezüglich sei auf die WO 2010/049076 A2 verwiesen, die hiermit vollständig als Bestandteil der vorliegenden Anmeldung in diese integriert ist. Die Beschreibung des allgemeinen Aufbaus der Projektionsbelichtungsanlage 1 ist ausschließlich exemplarisch zu verstehen. Sie dient der Erläuterung einer möglichen Anwendung des Gegenstands der vorliegenden Erfindung. Der Gegenstand der vorliegenden Erfindung kann auch in anderen optischen Systemen, insbesondere in alternativen Varianten von Projektionsbelichtungsanlagen eingesetzt werden.

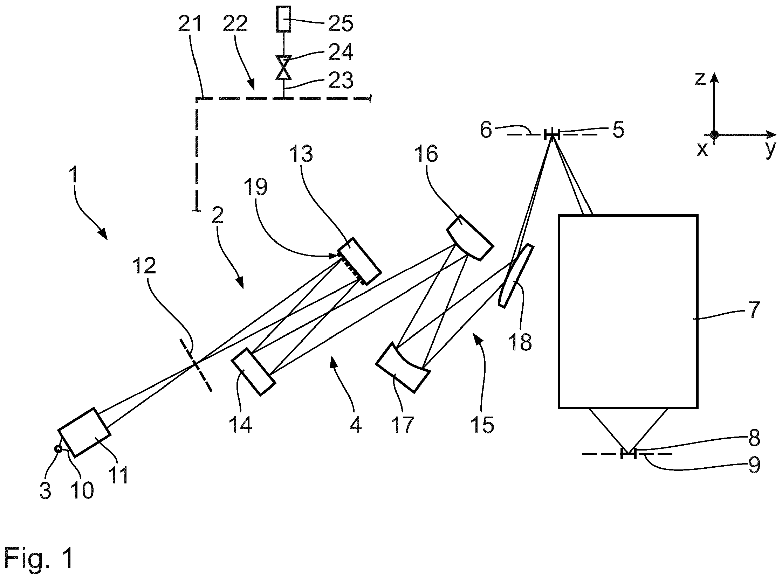

Fig. 1 zeigt schematisch in einem Meridionalschnitt eine Projektionsbelichtungsanlage 1 für die Mikrolithografie. Ein Beleuchtungssystem 2 der Projektionsbelichtungsanlage 1 hat neben einer Strahlungsquelle 3 eine Beleuchtungsoptik 4 zur Belichtung eines Objektfeldes 5 in einer Objektebene 6. Das Objektfeld 5 kann rechteckig oder bogenförmig mit einem x/y-Aspektverhältnis von beispielsweise 13/1 gestaltet sein. Belichtet wird hierbei ein im Objektfeld 5 angeordnetes und in der Fig. 1 nicht dargestelltes reflektierendes Retikel, das eine mit der Projektionsbelichtungsanlage 1 zur Herstellung mikro- bzw. nanostrukturierter Halbleiter-Bauelemente zu projizierende Struktur trägt. Eine Projektionsoptik 7 dient zur Abbildung des Objektfeldes 5 in ein Bildfeld 8 in einer Bildebene 9. Abgebildet wird die Struktur auf dem Retikel auf eine lichtempfindliche Schicht eines im Bereich des Bildfeldes 8 in der Bildebene 9 angeordneten Wafers, der in der Zeichnung nicht dargestellt ist.

Das Retikel, das von einem nicht dargestellten Retikelhalter gehalten ist, und der Wafer, der von einem nicht dargestellten Waferhalter gehalten ist, werden beim Betrieb der Projektionsbelichtungsanlage 1 synchron in der y-Richtung gescannt. Abhängig vom Abbildungsmaßstab der Projektionsoptik 7 kann auch ein gegenläufiges Scannen des Retikels relativ zum Wafer stattfinden.

Bei der Strahlungsquelle 3 handelt es sich um eine EUV-Strahlungsquelle mit einer emittierten Nutzstrahlung im Bereich zwischen 5 nm und 30 nm. Es kann sich dabei um eine Plasmaquelle, beispielsweise um eine GDPP-Quelle (Plasmaerzeugung durch Gasentladung, Gas Discharge Produced Plasma), oder um eine LPP-Quelle (Plasmaerzeugung durch Laser, Laser Produced Plasma) handeln. Auch andere EUV-Strahlungsquellen, beispielsweise solche, die auf einem Synchrotron oder auf einem Free Electron Laser (Freie Elektronenlaser, FEL) basieren, sind möglich.

EUV-Strahlung 10, die von der Strahlungsquelle 3 ausgeht, wird von einem Kollektor 11 gebündelt. Ein entsprechender Kollektor ist beispielsweise aus der EP 1 225 481 A2 bekannt. Nach dem Kollektor 11 propagiert die EUV-Strahlung 10 durch eine Zwischenfokusebene 12, bevor sie auf einen Feldfacettenspiegel 13 trifft. Der Feldfacettenspiegel 13 ist in einer Ebene der Beleuchtungsoptik 4 angeordnet, die zur Objektebene 6 optisch konjugiert ist. Der Feldfacettenspiegel 13 kann beabstandet zu einer zur Objektebene 6 konjugierten Ebene angeordnet sein. Er wird in diesem Fall allgemein als erster Facettenspiegel bezeichnet.

Die EUV-Strahlung 10 wird nachfolgend auch als Nutzstrahlung, Beleuchtungsstrahlung oder als Abbildungslicht bezeichnet.

Nach dem Feldfacettenspiegel 13 wird die EUV-Strahlung 10 von einem Pupillenfacettenspiegel 14 reflektiert. Der Pupillenfacettenspiegel 14 liegt entweder in der Eintrittspupillenebene der Projektionsoptik 7 oder in einer hierzu optisch konjugierten Ebene. Er kann auch beabstandet zu einer derartigen Ebene angeordnet sein.

Der Feldfacettenspiegel 13 und der Pupillenfacettenspiegel 14 sind aus einer Vielzahl von Einzelspiegeln aufgebaut, die nachfolgend noch näher beschrieben werden. Dabei kann die Unterteilung des Feldfacettenspiegels 13 in Einzelspiegel derart sein, dass jede der Feldfacetten, die für sich das gesamte Objektfeld 5 ausleuchten, durch genau einen der Einzelspiegel repräsentiert wird. Alternativ ist es möglich, zumindest einige oder alle der Feldfacetten durch eine Mehrzahl derartiger Einzelspiegel aufzubauen. Entsprechendes gilt für die Ausgestaltung der den Feldfacetten jeweils zugeordneten Pupillenfacetten des Pupillenfacettenspiegels 14, die jeweils durch einen einzigen Einzelspiegel oder durch eine Mehrzahl derartiger Einzelspiegel gebildet sein können.

Die EUV-Strahlung 10 trifft auf die beiden Facettenspiegel 13, 14 unter einem definierten Einfallswinkel auf. Die beiden Facettenspiegel werden insbesondere im Bereich eines normal incidence-Betriebs, d. h. mit einem Einfallswinkel, der kleiner oder gleich 25° zur Spiegelnormalen ist, mit der EUV-Strahlung 10 beaufschlagt. Auch eine Beaufschlagung unter streifendem Einfall (grazing incidence) ist möglich. Der Pupillenfacettenspiegel 14 ist in einer Ebene der Beleuchtungsoptik 4 angeordnet, die eine Pupillenebene der Projektionsoptik 7 darstellt bzw. zu einer Pupillenebene der Projektionsoptik 7 optisch konjugiert ist. Mithilfe des Pupillenfacettenspiegels 14 und einer abbildenden optischen Baugruppe in Form einer Übertragungsoptik 15 mit in der Reihenfolge des Strahlengangs für die EUV-Strahlung 10 bezeichneten Spiegeln 16, 17 und 18 werden die Feldfacetten des Feldfacettenspiegels 13 einander überlagernd in das Objektfeld 5 abgebildet. Der letzte Spiegel 18 der Übertragungsoptik 15 ist ein Spiegel für streifenden Einfall ("Grazing incidence Spiegel"). Die Übertragungsoptik 15 wird zusammen mit dem Pupillenfacettenspiegel 14 auch als Folgeoptik zur Überführung der EUV-Strahlung 10 vom Feldfacettenspiegel 13 hin zum Objektfeld 5 bezeichnet. Das Beleuchtungslicht 10 wird von der Strahlungsquelle 3 hin zum Objektfeld 5 über eine Mehrzahl von Ausleuchtungskanälen geführt. Jedem dieser Ausleuchtungskanäle ist eine Feldfacette des Feldfacettenspiegels 13 und eine dieser nachgeordnete Pupillenfacette des Pupillenfacettenspiegels 14 zugeordnet. Die Einzelspiegel des Feldfacettenspiegels 13 und des Pupillenfacettenspiegels 14 können aktuatorisch verkippbar sein, sodass ein Wechsel der Zuordnung der Pupillenfacetten zu den Feldfacetten und entsprechend eine geänderte Konfiguration der Ausleuchtungskanäle erreicht werden kann. Es resultieren unterschiedliche Beleuchtungssettings, die sich in der Verteilung der Beleuchtungswinkel des Beleuchtungslichts 10 über das Objektfeld 5 unterscheiden.

Zur Erleichterung der Erläuterung von Lagebeziehungen wird nachfolgend unter anderem ein globales kartesisches xyz-Koordinatensystem verwendet. Die x-Achse verläuft in der Fig. 1 senkrecht zur Zeichenebene auf den Betrachter zu. Die y-Achse verläuft in der Fig. 1 nach rechts. Die z-Achse verläuft in der Fig. 1 nach oben.

Unterschiedliche Beleuchtungssettings können über eine Verkippung der Einzelspiegel des Feldfacettenspiegels 13 und einen entsprechenden Wechsel der Zuordnung dieser Einzelspiegel des Feldfacettenspiegels 13 zu den Einzelspiegeln des Pupillenfacettenspiegels 14 erreicht werden. Abhängig von der Verkippung der Einzelspiegel des Feldfacettenspiegels 13 werden die diesen Einzelspiegeln neu zugeordneten Einzelspiegel des Pupillenfacettenspiegels 14 so durch Verkippung nachgeführt, dass wiederum eine Abbildung der Feldfacetten des Feldfacettenspiegels 13 in das Objektfeld 5 gewährleistet ist.

Im Folgenden werden weitere Aspekte der Beleuchtungsoptik 4 beschrieben.

Der eine Feldfacettenspiegel 13 in Form einer Vielspiegel-Anordnung, welche auch als Multi- bzw. Mikrospiegel-Array (MMA) bezeichnet wird, bildet ein Beispiel für eine optische Baugruppe zur Führung der Nutzstrahlung 10, also des EUV-Strahlungsbündels. Der Feldfacettenspiegel 13 ist als mikroelektromechanisches System (MEMS) ausgebildet. Er weist eine Vielzahl von matrixartig zeilen- und spaltenweise in einem Spiegel-Array 19 angeordneten Einzelspiegeln 20 auf. Die Spiegel-Arrays 19 sind modular ausgeführt. Sie können auf einer als Grundplatte ausgebildeten Tragestruktur angeordnet werden. Hierbei können im Wesentlichen beliebig viele der Spiegel-Arrays 19 nebeneinander angeordnet sein. Die Gesamt-Reflexionsfläche, welche durch die Gesamtheit sämtlicher Spiegel-Arrays 19, insbesondere deren Einzelspiegel 20, gebildet wird, ist somit beliebig erweiterbar. Die Spiegel-Arrays sind insbesondere derart ausgebildet, dass sie eine im Wesentlichen lückenlose Parkettierung einer Ebene ermöglichen. Das Verhältnis der Summe der Reflexionsflächen 26 der Einzelspiegel 20 zu der Gesamtfläche, welche von Spiegel-Arrays 19 abgedeckt wird, wird auch als Integrations-Dichte bezeichnet. Diese Integrations-Dichte beträgt insbesondere mindestens 0,5, insbesondere mindestens 0,6, insbesondere mindestens 0,7, insbesondere mindestens 0,8, insbesondere mindestens 0,9.

Die Einzelspiegel 20 sind aktuatorisch verkippbar ausgelegt, wie nachfolgend noch erläutert wird. Insgesamt weist der Feldfacettenspiegel 13 etwa 100000 der Einzelspiegel 20 auf. Je nach Größe der Einzelspiegel 20 kann der Feldfacettenspiegel 13 auch eine andere Anzahl an Einzelspiegeln 20 aufweisen. Die Anzahl der Einzelspiegel 20 des Feldfacettenspiegels 13 beträgt insbesondere mindestens 1000, insbesondere mindestens 5000, insbesondere mindestens 10000. Sie kann bis zu 100000, insbesondere bis zu 300000, insbesondere bis zu 500000, insbesondere bis zu 1000000, insbesondere bis zu 10000000 betragen.

Vor dem Feldfacettenspiegel 13 kann ein Spektralfilter angeordnet sein, der die Nutzstrahlung 10 von anderen, nicht für die Projektionsbelichtung nutzbaren Wellenlängenkomponenten der Emission der Strahlungsquelle 3 trennt. Der Spektralfilter ist nicht dargestellt.

Der Feldfacettenspiegel 13 wird mit Nutzstrahlung 10 mit einer Leistung von beispielsweise 840 W und einer Leistungsdichte von 6,5 kW/m² beaufschlagt.

Das gesamte Einzelspiegel-Array des Facettenspiegels 13 hat beispielsweise einen Durchmesser von 500 mm und ist dicht gepackt mit den Einzelspiegeln 20 ausgelegt. Die Einzelspiegel 20 repräsentieren, soweit eine Feldfacette durch jeweils genau einen Einzelspiegel realisiert ist, bis auf einen Skalierungsfaktor die Form des Objektfeldes 5. Der Facettenspiegel 13 kann aus 500 jeweils eine Feldfacette repräsentierenden Einzelspiegeln 20 mit einer Dimension von etwa 5 mm in einer Richtung und 100 mm in einer hierzu senkrechten Richtung gebildet sein. Alternativ zur Realisierung jeder Feldfacette durch genau einen Einzelspiegel 20 kann jede der Feldfacetten durch Gruppen von kleineren Einzelspiegeln 20 approximiert werden. Eine Feldfacette mit Dimensionen von 5 mm in einer Richtung und von 100 mm in einer hierzu senkrechten Richtung kann z. B. mittels eines 1 × 20-Arrays von Einzelspiegeln 20 der Dimension 5 mm x 5 mm bis hin zu einem 10 x 200-Array von Einzelspiegeln 20 mit den Dimensionen 0,5 mm x 0,5 mm aufgebaut sein. Die kürzere Richtung ist hierbei insbesondere derart ausgerichtet, dass sie bei einer Abbildung in das Objektfeld 5 der Scanrichtung entspricht, beziehungsweise parallel zu dieser verläuft.

Zum Umstellen der Beleuchtungssettings werden die Kippwinkel der Einzelspiegel 20 verstellt. Die Kippwinkel weisen insbesondere einen Verlagerungsbereich von ± 50 mrad, insbesondere ± 100 mrad auf. Bei der Einstellung der Kippposition der Einzelspiegel 20 wird eine Genauigkeit von besser als 0,2 mrad, insbesondere besser als 0,1 mrad erreicht.

Die Einzelspiegel 20 des Feldfacettenspiegels 13 und des Pupillenfacettenspiegels 14 bei der Ausführung der Beleuchtungsoptik 4 nach Fig. 1 tragen Multilayer-Beschichtungen zur Optimierung ihrer Reflektivität bei der Wellenlänge der Nutzstrahlung 10. Die Temperatur der Multilayer-Beschichtungen sollte 425 K beim Betreiben der Projektionsbelichtungs-anlage 1 nicht überschreiten. Dies wird durch einen geeigneten Aufbau der Einzelspiegel 20 erreicht. Für Details wird auf DE 10 2013 206 529 A1 verwiesen, die hiermit vollständig in die vorliegende Anmeldung integriert ist.

Die Einzelspiegel 20 der Beleuchtungsoptik 4 sind in einer evakuierbaren Kammer 21 untergebracht, von der in der Fig. 1 eine Begrenzungswand 22 angedeutet ist. Die Kammer 21 kommuniziert über eine Fluidleitung 23, in der ein Absperrventil 24 untergebracht ist, mit einer Vakuumpumpe 25. Der Betriebsdruck in der evakuierbaren Kammer 21 beträgt einige Pascal, insbesondere 3 Pa bis 5 Pa (Partialdruck H₂). Alle anderen Partialdrücke liegen deutlich unterhalb von 1 × 10⁻⁷ mbar.

Der die Mehrzahl von Einzelspiegeln 20 aufweisende Spiegel bildet zusammen mit der evakuierbaren Kammer 21 eine optische Baugruppe zur Führung eines Bündels der EUV-Strahlung 10.

Jeder der Einzelspiegel 20 kann eine Reflexionsfläche 26 mit Abmessungen von 0,1 mm x 0,1 mm, 0,5 mm x 0,5 mm, 0,6 mm x 0,6 mm oder auch von bis zu 5 mm x 5 mm und größer aufweisen. Die Reflexionsfläche 26 kann auch kleinere Abmessungen aufweisen. Sie weist insbesondere Seitenlängen im µm- oder unteren mm-Bereich auf. Die Einzelspiegel 20 werden daher auch als Mikrospiegel bezeichnet. Die Reflexionsfläche 26 ist Teil eines Spiegelkörpers 27 des Einzelspiegels 20. Der Spiegelkörper 27 trägt die Mehrlagen-(Multilayer)-Beschichtung.

Mit Hilfe der Projektionsbelichtungsanlage 1 wird wenigstens ein Teil des Retikels auf einen Bereich einer lichtempfindlichen Schicht auf dem Wafer zur lithografischen Herstellung eines mikro- bzw. nanostrukturierten Bauelements, insbesondere eines Halbleiterbauelements, z.B. eines Mikrochips abgebildet. Je nach Ausführung der Projektionsbelichtungsanlage 1 als Scanner oder als Stepper werden das Retikel und der Wafer zeitlich synchronisiert in der y-Richtung kontinuierlich im Scannerbetrieb oder schrittweise im Stepperbetrieb verfahren.

Im Folgenden werden weitere Details und Aspekte der Spiegel-Arrays 19, insbesondere der optischen Bauelemente, welche die Einzelspiegel 20 umfassen, beschrieben.

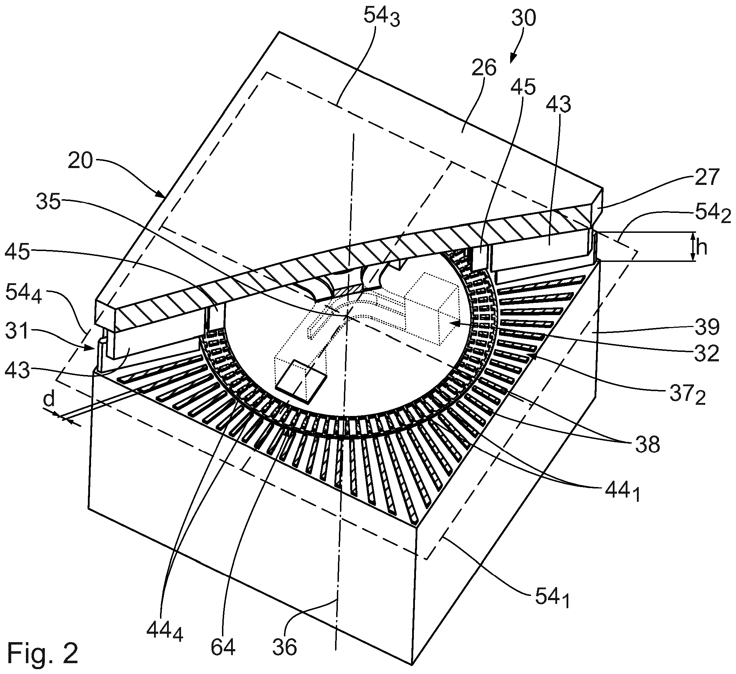

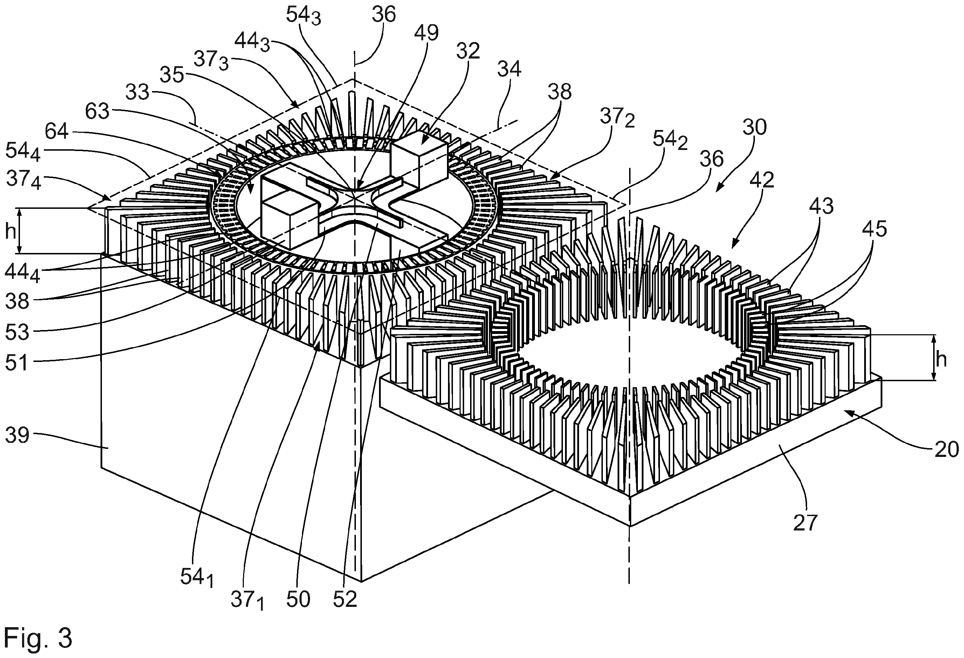

Zunächst wird unter Bezugnahme auf die Fig. 2 und 3 eine erste Variante eines optischen Bauelements 30 mit einem Einzelspiegel 20 sowie insbesondere der Verlagerungs-Einrichtung 31 zur Verlagerung, insbesondere zur Verschwenkung des Einzelspiegels 20, beschrieben.

Die Darstellung gemäß Fig. 3 entspricht der gemäß Fig. 2, wobei in der Fig. 3 der Spiegelkörper 27 des Einzelspiegels 20 zur Seite weggeklappt ist. Hierdurch werden die Strukturen der Verlagerungs-Einrichtung 31 sowie der Sensor-Einrichtung besser sichtbar.

Das optische Bauelement 30 umfasst den Einzelspiegel 20, welcher insbesondere als Mikrospiegel ausgebildet ist. Der Einzelspiegel 20 umfasst den vorgehend beschriebenen Spiegelkörper 27, auf dessen Vorderseite die Reflexionsfläche 26 ausgebildet ist. Die Reflexionsfläche 26 ist insbesondere durch eine Viellagenstruktur gebildet. Sie ist insbesondere strahlungsreflektierend für die Beleuchtungsstrahlung 10, insbesondere für EUV-Strahlung.

Gemäß der in den Figuren dargestellten Variante ist die Reflexionsfläche 26 quadratisch ausgebildet, jedoch teilweise angeschnitten dargestellt, um auch die Aktuatorik zu zeigen. Sie ist allgemein rechteckig ausgebildet. Sie kann auch dreieckig oder sechseckig ausgebildet sein. Sie ist insbesondere derart kachelartig ausgebildet, dass eine lückenlose Parkettierung einer Ebene mit den Einzelspiegeln 20 möglich ist. Der Einzelspiegel 20 ist mittels eines nachfolgend noch näher beschriebenen Gelenks 32 gelagert. Er ist insbesondere derart gelagert, dass er zwei Kipp-Freiheitsgrade aufweist. Das Gelenk 32 ermöglicht insbesondere die Verkippung des Einzelspiegels 20 um zwei Kippachsen 33, 34. Die Kippachsen 33, 34 stehen senkrecht aufeinander. Sie schneiden sich in einem zentralen Schnittpunkt, welcher als effektiver Schwenkpunkt 35 bezeichnet wird.

Sofern sich der Einzelspiegel 20 in einer unverschwenkten Neutralposition befindet, so liegt der effektive Schwenkpunkt 35 auf einer Flächennormalen 36, welche durch einen zentralen Punkt, insbesondere den geometrischen Schwerpunkt der Reflexionsfläche 26 verläuft.

Sofern nichts anderes angegeben ist, wird im Folgenden unter der Richtung der Flächennormalen 36 stets die Richtung derselben in der unverkippten Neutralstellung des Einzelspiegels 20 verstanden.

Im Folgenden wird zunächst die Verlagerungs-Einrichtung 31 näher beschrieben.

Die Verlagerungs-Einrichtung 31 umfasst eine Elektrodenstruktur mit Aktuator-Wandler-Statorelektroden 37; und Aktuator-Wandler-Spiegelelektroden 42. Gemäß der in den Figuren 2 und 3 dargestellten Variante umfasst die Elektrodenstruktur vier Aktuator-Wandler-Statorelektroden 37₁, 37₂ ,37₃ und 37₄. Die Anzahl der Aktuator-Wandler-Statorelektroden 37; beträgt allgemein mindestens 2. Sie kann 3, 4 oder mehr betragen.

Sämtliche Aktuator-Wandlerelektroden 37ᵢ, 42 sind als Kamm-Elektroden mit einer Mehrzahl von Kammfingern 38 ausgebildet. Die jeweils komplementären Kammfinger von Spiegel und Stator greifen hierbei ineinander. Die Kämme der einzelnen Aktuator-Elektroden 37; umfassen jeweils 30 Aktuator-Wandler Stator Kammfinger 38, welche im Folgenden verkürzt auch als Statorkammfinger oder lediglich als Kammfinger bezeichnet werden. Eine jeweils andere Anzahl ist ebenso möglich. Die Anzahl der Kammfinger 38 der Aktuator-Wandler-Statorelektroden 37; beträgt insbesondere mindestens 2, insbesondere mindestens 3, insbesondere mindestens 5, insbesondere mindestens 10. Sie kann bis zu 50, insbesondere bis zu 100 betragen.

Die Kämme der Aktuator-Wandler-Spiegelelektroden 42 umfassen entsprechend Aktuator-Wandler-Spiegelkammfinger 43, welche im Folgenden verkürzt auch als Spiegelkammfinger oder lediglich als Kammfinger bezeichnet werden. Die Anzahl der Spiegelkammfinger 43 entspricht der Anzahl der Statorkammfinger. Sie kann auch jeweils um eins pro Elektrode von der Anzahl der Statorkammfinger abweichen.

Die Kammfinger 38 sind derart angeordnet, dass sie in Bezug auf die Flächennormale 36 bzw. den effektiven Schwenkpunkt 35 in radialer Richtung verlaufen. Gemäß einer in den Figuren nicht dargestellten Variante können die Kammfinger 38, 43 auch tangential zu Kreisen um den effektiven Schwenkpunkt 35 angeordnet sein. Sie können auch eine Ausbildung aufweisen, welche Ausschnitten aus konzentrischen Kreiszylinder-Mantelflächen um die Flächennormale 36 entsprechen.

Sämtliche der Aktuator-Wandler-Statorelektroden 37; sind auf einer Tragestruktur in Form eines Substrats 39 angeordnet. Sie sind insbesondere ortsfest auf dem Substrat 39 angeordnet. Sie sind insbesondere in einer einzigen, durch die Vorderseite des Substrats 39 definierten Ebene angeordnet. Diese Ebene wird auch als Aktuator-Ebene oder als Kamm-Ebene bezeichnet.

Als Substrat 39 dient insbesondere ein Wafer. Das Substrat 39 wird auch als Grundplatte bezeichnet.

Die Aktuator-Wandler-Statorelektroden 37; sind jeweils in einem Bereich auf dem Substrat 39 angeordnet, welcher einerseits eine quadratisch äußere Einhüllende, andererseits eine kreisförmige innere Einhüllende aufweist. Alternativ hinzu können die Aktuator-Wandler-Statorelektroden 37; auch in einem kreisringförmigen Bereich auf dem Substrat 39 angeordnet sein. Hierbei ist auch die äußere Einhüllende kreisförmig ausgebildet. Die einzelnen Aktuator-Wandler-Statorelektroden 37; sind insbesondere jeweils in kreisringabschnittförmigen Bereichen angeordnet. Die Elektrodenstruktur insgesamt, das heißt sämtliche Aktuator-Wandler-Statorelektroden 37; sind in einem Bereich angeordnet, welcher eine äußere Einhüllende aufweist, die gerade derjenigen der Reflexionsfläche des Einzelspiegels 20 entspricht. Sie kann auch in einen etwas kleineren, insbesondere etwa 5 % bis 25 % kleineren Bereich angeordnet sein.

Die Elektrodenstruktur weist eine Radiärsymmetrie auf. Sie weist insbesondere eine vierzählige Radiärsymmetrie auf. Die Elektrodenstruktur kann auch eine andere Radiärsymmetrie aufweisen. Sie kann insbesondere eine dreizählige Radiärsymmetrie aufweisen. Sie weist insbesondere eine k-zählige Radiärsymmetrie auf, wobei k die Anzahl der Aktuator-Wandler-Statorelektroden 37; angibt. Abgesehen von der Unterteilung der Elektrodenstruktur im Querschnitt in die unterschiedlichen Aktuator-Wandler-Statorelektroden 37; weist die Elektrodenstruktur eine n-zählige Radiärsymmetrie auf, wobei n gerade der Gesamtzahl der Kammfinger 38 sämtlicher Aktuator-Wandler-Statorelektroden 37; entspricht. Die Kammfinger 38 der Aktuator-Wandler-Statorelektroden 37; können jedoch unterschiedliche Längen aufweisen.

Die einzelnen Aktuator-Wandler-Statorelektroden 37; können unterschiedlich ausgebildet sein. Sie können insbesondere in Abhängigkeit der mechanischen Eigenschaften des Gelenks 32 ausgebildet sein. Sie können auch identisch ausgebildet sein.

Die Kammfinger 38 sind radial zum effektiven Schwenkpunkt 35, bzw. radial zur Ausrichtung der Flächennormalen 36 im unverschwenkten Neutralzustand des Einzelspiegels 20 angeordnet.

Bei Einzelspiegeln 20, deren Spiegelkörper 27 Abmessungen von 1 mm · 1 mm aufweisen, weisen die Kammfinger 38 an ihrem in radialer Richtung äußeren Ende eine Dicke d im Bereich von 8 µm bis 20 µm auf. Allgemein liegt die maximale Dicke d der Kammfinger 38 an ihrem in Radialrichtung äußeren Ende im Bereich von 1 µm bis 30 µm.

Die Kammfinger 38 weisen eine Höhe h, das heißt eine Erstreckung in Richtung der Flächennormalen 36, im Bereich von 10 µm bis 150 µm, insbesondere im Bereich von 50 µm bis 120 µm auf. Andere Werte sind ebenfalls denkbar. Die Höhe h ist in Radialrichtung konstant. Sie kann auch in Radialrichtung abnehmen. Hierdurch können größere Kippwinkel ermöglicht werden, ohne dass dies dazu führt, dass die Kammfinger der Aktuator-Spiegelelektrode 42 auf die Grundplatte auftreffen.

Benachbarte Kammfinger 38, 43 der Aktuatorelektroden 37; einerseits und der Aktuator-Spiegelelektroden 42 andererseits weisen im unverschwenkten Zustand des Einzelspiegels 20 einen Mindestabstand im Bereich von 1 µm bis 10 µm, insbesondere im Bereich von 3 µm bis 7 µm, insbesondere von etwa 5 µm auf. Für Einzelspiegel 20 mit kleineren oder größeren Abmessungen können diese Werte entsprechend skaliert werden.

Bei diesem Mindestabstand handelt es sich um den minimalen Abstand benachbarter Spiegel- und Statorkammfinger gemessen im neutralen, unverschwenkten Zustand des Einzelspiegels 20. Bei einer Verkippung des Einzelspiegels 20 können sich die Kammfinger aneinander annähern. Der Mindestabstand ist derart gewählt, dass es auch bei einer maximalen Verkippung des Einzelspiegels 20 nicht zu einer Kollision benachbarter Spiegel- und Statorkammfinger kommt. Hierbei sind auch Fertigungstoleranzen berücksichtigt. Derartige Fertigungstoleranzen liegen bei wenigen Mikrometern, insbesondere bei höchstens 3 µm, insbesondere höchstens 2 µm, insbesondere höchstens 1 µm.

Die maximal mögliche Annäherung benachbarter Kammfinger 38, 43 lässt sich aus den geometrischen Details derselben und deren Anordnung sowie der maximal möglichen Verkippung des Einzelspiegels 20 auf einfache Weise bestimmen. Bei der vorliegenden Ausführungsform beträgt die maximale Annäherung benachbarter Kammfinger 38, 43 bei einer Verkippung des Einzelspiegels 20 um 100 mrad etwa 2 µm. Die maximale Annäherung beträgt insbesondere weniger als 10 µm, insbesondere weniger als 7 µm, insbesondere weniger als 5 µm, insbesondere weniger als 3 µm.

Die Aktuator-Wandler-Statorelektroden 37; wirken jeweils mit einer Aktuator-Spiegelelektrode 42 zusammen. Die Aktuator-Spiegelelektrode 42 ist mit dem Spiegelkörper 27 verbunden. Die Aktuator-Spiegelelektrode 42 ist insbesondere mechanisch fix mit dem Spiegelkörper 27 verbunden. Die Aktuator-Wandler-Spiegelelektroden 42 bilden eine Gegenelektrode zu den Aktuator-Wandler-Statorelektroden 37;. Sie werden daher auch einfach als Gegenelektrode bezeichnet.

Die Aktuator-Spiegelelektrode 42 bildet eine passive Elektrodenstruktur. Hierunter sei verstanden, dass die Aktuator-Spiegelelektrode 42 mit einer fixen, konstanten Spannung beaufschlagt wird.

Die Aktuator-Spiegelelektrode 42 ist komplementär zu den Aktuator-Wandler-Statorelektroden 37; ausgebildet. Sie bildet insbesondere einen Ring mit Aktuator-Wandler Spiegel Kammfingern 43, welche im Folgenden vereinfachend auch als Spiegel-Kammfinger oder lediglich als Kammfinger 43 bezeichnet werden. Die Spiegel-Kammfinger 43 der Aktuator-Spiegelelektrode 42 entsprechen in ihren geometrischen Eigenschaften im Wesentlichen den Stator-Kammfingern 38 der Aktuator-Wandler-Statorelektroden 37;.

Sämtliche der Kammfinger 38, 43 können dieselbe Höhe h, d. h. identische Abmessungen in Richtung der Flächennormalen 36 aufweisen. Dies erleichtert den Herstellungsprozess.

Die Spiegel-Kammfinger 43 der Aktuator-Spiegelelektrode 42 können in Richtung der Flächennormalen 36 auch eine andere Höhe aufweisen als die Stator-Kammfinger 38 der aktiven Aktuator-Wandler-Statorelektroden 37;.

Die Kammfinger 38, 43 können eine in Radialrichtung abnehmende Höhe h aufweisen. Es ist auch möglich, die Kammfinger 38, 43 im Bereich der Ecken des optischen Bauelements 30 kürzer auszubilden als die übrigen Kammfinger 38, 43. Hierdurch kann ein größerer Kippwinkel des Einzelspiegels 20 ermöglicht werden.

Die Aktuator-Spiegelelektrode 42 ist insbesondere derart ausgebildet, dass jeweils einer der Kammfinger 43 der Aktuator-Spiegelelektrode 42 in einem Zwischenraum zwischen zwei der Kammfinger 38 der Aktuator-Wandler-Statorelektroden 37; eintauchen kann.

Die Aktuator-Spiegelelektrode 42 ist elektrisch leitfähig mit dem Spiegelkörper 27 verbunden. Ihre Kammfinger 43 sind daher äquipotential. Der Spiegelkörper 27 ist über eine elektrisch leitfähige Gelenkfeder niederohmig mit der Grundplatte verbunden. Prinzipiell kann man auch das Spiegelsubstrat, das heißt den Spiegelkörper 27, die Aktuator-Spiegelelektroden 42 und Sensor-Spiegelelektroden 45 über getrennte Zuleitungen über das Festkörpergelenk 32 individuell elektrisch anbinden und so beispielsweise auf unterschiedliche Potentiale legen oder bezüglich Störungen und/oder Übersprechen entkoppeln. Die Grundplatte kann geerdet sein, muss aber nicht. Alternativ kann der Spiegel, insbesondere über eine leitfähige Gelenkfeder mit einer Spannungsquelle verbunden sein. Der Spiegelkörper 28 kann auch galvanisch von der Grundplatte entkoppelt sein. Hierdurch ist es möglich den Spiegel mit einer festen oder variablen Bias Spannung zu beaufschlagen.

Die Aktuator-Wandler-Statorelektroden 37; sind zur Verschwenkung des Einzelspiegels 20 mit einer Aktuator-Spannung U_{A} beaufschlagbar. Die Aktuator-Wandler-Statorelektroden 37; werden daher auch als aktive Aktuator-Wandler-Statorelektroden 37ᵢ bezeichnet. Zur Beaufschlagung der Aktuator-Wandler-Statorelektroden 37; mit der Aktuator-Spannung U_{A} ist eine in den Figuren nicht dargestellte Spannungsquelle vorgesehen. Die Aktuator-Spannung U_{A}, beträgt höchstens 200 Volt, insbesondere höchstens 100 Volt. Durch geeignete Beaufschlagung einer Auswahl der Aktuator-Wandler-Statorelektroden 37; mit der Aktuator-Spannung U_{A} kann der Einzelspiegel 20 um bis zu 50 mrad, insbesondere bis zu 100 mrad, insbesondere bis 150mrad aus einer Neutralstellung verkippt werden. Alternativ können die Aktuatoren auch mit einer Ladungsquelle (Stromquelle) angesteuert werden.

Die unterschiedlichen Aktuator-Wandler-Statorelektroden 37; können zur Verschwenkung des Einzelspiegels 20 mit unterschiedlichen Aktuator-Spannungen U_{Ai} beaufschlagt werden. Zur Steuerung der Aktuator-Spannungen U_{Ai} ist eine in den Figuren nicht dargestellte SteuerEinrichtung vorgesehen.

Zur Verkippung eines der Einzelspiegel 20 wird an eine der Aktuator-Wandler-Statorelektroden 37; eine Aktuator-Spannung U_{A1} angelegt. Gleichzeitig wird an der bezüglich der Flächennormalen 36 gegenüberliegenden Aktuator-Wandler-Statorelektrode 37ⱼ eine hiervon abweichende Aktuator-Spannung U_{A2} ≠ U_{A1} angelegt. Hierbei kann U_{A2} = 0 Volt sein. Es ist insbesondere möglich, ausschließlich eine der Aktuator-Wandler-Statorelektroden 37; mit der Aktuator-Spannung U_{A1} zu beaufschlagen, während sämtliche anderen Aktuator-Wandler-Statorelektroden 37ⱼ auf einer Spannung von 0 Volt gehalten werden.

Bei einer Verkippung des Einzelspiegels 20 tauchen die Kammfinger der Aktuator-Spiegelelektrode 42 auf einer Seite, insbesondere im Bereich der mit der Aktuator-Spannung U_{A} beaufschlagten Aktuator-Wandler-Statorelektrode 37; tiefer zwischen die Kammfinger 38 dieser Aktuator-Wandler-Statorelektrode 37; ein. Auf der gegenüberliegenden Seite der Kippachse 33 taucht die Aktuator-Spiegelelektrode 42 weniger tief in die Aktuator-Wandler-Statorelektroden 37ⱼ ein. Es kann sogar zu einem zumindest bereichsweisen Austauchen der Aktuator-Spiegelelektrode 42 aus den Aktuator-Wandler-Statorelektroden 37ⱼ kommen.

Der Kammüberlapp, das heißt die Eintauchtiefe der Aktuator-Spiegelelektrode 42 zwischen die Aktuator-Wandler-Statorelektroden 37; liegt bei einer Spiegeldimension von etwa 0,5mm x 0,5mm in der Neutralstellung des Einzelspiegels 20 im Bereich von 0 µm bis 50 µm.

Die Abmessungen und Abstände zwischen den Kammfingern 43 der Aktuator-Spiegelelektrode 42 und den Kammfingern 38 der Aktuator-Wandler-Statorelektroden 37; werden insbesondere so gewählt, dass sich die Kammfinger 43 und die Kammfinger 38 bei einer maximalen Verkippung des Spiegels 20, beispielsweise um etwa 100 mrad, nicht näher als 1 µm kommen. Die Kammfinger 43 der Aktuator-Spiegelelektrode 42 und die Kammfinger 38 der Aktuator-Wandler-Statorelektroden 37; sind somit in jeder Verschwenkposition des Spiegels 20 beabstandet zueinander, insbesondere berührungsfrei. Die Eintauchtiefe, das heißt der Kammüberlapp, ist insbesondere derart gewählt, dass dies sichergestellt ist.

Gemäß einer Alternative sind die Kammfinger 38, 43 im äußeren Bereich etwas kürzer und weisen daher einen geringeren Überlapp, das heißt eine geringere Eintauchtiefe, auf. Die Eintauchtiefe im äußersten Bereich kann beispielsweise etwa halb so groß sein wie die Eintauchtiefe im inneren Bereich. Auch diese Angaben beziehen sich auf die Neutralposition des Spiegels 20.

Durch eine Abhängigkeit der Eintauchtiefe der Kammfinger 38, 43 von deren Radialposition lässt sich auch die Charakteristik, insbesondere die Linearität der Aktuierung, beeinflussen.

Da sämtliche der Aktuator-Wandler-Statorelektroden 37; in einer einzigen Ebene, der Aktuator-Ebene 40, angeordnet sind, kann auf eine komplexe, serielle Kinematik verzichtet werden. Die Verlagerungs-Einrichtung 31 zeichnet sich durch eine Parallelkinematik aus.

Die Verlagerungs-Einrichtung 31 weist insbesondere keine beweglich angeordneten aktiven Komponenten auf. Sämtliche der mit der Aktuator-Spannung U_{A} beaufschlagbaren Aktuator-Wandler-Statorelektroden 37ᵢ sind unbeweglich ortsfest auf dem Substrat 39 angeordnet.

Zur Erfassung der Verschwenkposition des Einzelspiegels 20 ist eine Sensor-Einrichtung vorgesehen. Die Sensor-Einrichtung kann einen Bestandteil der Verlagerungs-Einrichtung 31 bilden.

Die Sensor-Einrichtung umfasst Sensor-Wandlerspiegelelektroden 45 und Sensor-Wandlerstatorelektroden 44ᵢ. Die Sensor-Wandlerspiegelelektroden 45 sind am Einzelspiegel 20 angeordnet. Sie bilden bewegliche Elektroden.

Die Sensor-Einheit umfasst vier Sensor-Wandlerstatorelektroden 44₁ bis 44₄. Die Sensor-Wandlerstatorelektroden 44; werden vereinfachend auch lediglich als Sensor-Elektroden bezeichnet. Es ist für die Ansteuerung vorteilhaft, wenn die Anzahl der Sensor-Wandlerstatorelektroden 44; gerade der Anzahl der Aktuator-Wandler-Statorelektroden 37ᵢ entspricht. Die Anzahl der Sensor-Wandlerstatorelektroden 44; kann jedoch auch von der Anzahl der Aktuator-Wandler-Statorelektroden 37; abweichen.

Die Sensor-Einrichtung wird nachfolgend noch näher beschrieben. Die Sensor-Wandlerstatorelektroden 44; sind in einem ringförmigen Bereich auf dem Substrat 39 angeordnet. Sie sind insbesondere in einem Bereich innerhalb der Aktuator-Wandlerstatorelektroden 37; angeordnet. Die ringförmigen Bereiche der Aktuator-Wandlerstatorelektroden 37; und der Sensor-Wandlerstatorelektroden 44; können konzentrische Kreise bilden.

Die Aktuator-Wandler-Statorelektroden 37; sind jeweils in Quadranten 54₁ bis 54₄ auf dem Substrat 39 angeordnet. Die Sensor-Wandlerstatorelektroden 44; sind jeweils in demselben Quadranten 54₁ bis 54₄ angeordnet wie jeweils eine der Aktuator-Wandler-Statorelektroden 37;. Die Sensor-Wandlerstatorelektroden 44; im selben Quadranten 54₁ bis 54₄ können jeweils zu Gruppen zusammengefasst sein, wobei sämtliche Elektroden einer Gruppe zur Ausgabe desselben Signals beitragen. Die Aktuator-Einrichtung 31, insbesondere die Anordnung und Ausbildung der Aktuator-Wandler-Statorelektroden 37; hat im Wesentlichen dieselben Symmetrieeigenschaften wie die Reflexionsfläche 26 des Einzelspiegels 20. Die Sensor-Einrichtung, insbesondere die Sensor-Wandlerstatorelektroden 44ᵢ, hat im Wesentlichen dieselben Symmetrieeigenschaften wie die Reflexionsfläche 26 des Einzelspiegels 20. Die Sensor-Einrichtung, insbesondere die Sensor-Wandlerstatorelektroden 44ᵢ, können auch eine Radiärsymmetrie aufweisen.

Jeweils zwei einander bezüglich des effektiven Schwenkpunkts 35 gegenüberliegende Gruppen von Sensor-Wandlerstatorelektroden 44; sind differenziell verschaltet. Eine derartige Verschaltung ist jedoch nicht zwingend notwendig. Allgemein ist es vorteilhaft, wenn jeweils zwei einander bezüglich des effektiven Schwenkpunkts 35 gegenüberliegende Sensor-Elektroden 44; oder entsprechende Gruppen derartiger Sensor-Elektroden 44; derart ausgebildet und angeordnet sind, dass sie differenziell auslesbar sind.

Die Sensor-Wandlerstatorelektroden 44; sind als Kamm-Elektroden ausgebildet. Die Sensor-Wandlerstatorelektroden 44; können insbesondere entsprechend den Aktuator-Wandlerstatorelektroden 37ᵢ, auf deren Beschreibung hiermit verwiesen wird, ausgebildet sein.

Die Sensor-Wandlerstatorelektroden 44; umfassen jeweils eine Sensor-Wandlerstatorsenderelektrode 47, im Folgenden auch kurz Sender-Elektrode, und eine Sensor-Wandlerstatorempfängerelektrode, im Folgenden auch kurz Empfänger-Elektrode, 48. Sowohl die sensor-Wandlerstatorsenderelektrode 47 als auch die Sensor-Wandlerstatorempfängerelektrode 48 weisen eine Kammstruktur auf. Sie umfassen insbesondere eine Mehrzahl von Kammfingern. Die Kammfinger der Sensor-Wandlerstatorsenderelektrode 47 sind insbesondere alternierend zu den Kammfingern der Sensor-Wandlerstatorempfängerelektrode 48 angeordnet.

Die Sensor-Einrichtung umfasst für jede der Sensor-Wandlerstatorelektroden 44; eine Sensor-Wandlerspiegelelektrode 45. Gemäß einer vorteilhaften Ausführungsform bilden die Sensor-Wandlerspiegelelektroden 45 jeweils eine Abschirm-Einheit der Sensor-Wandlerstatorelektroden 44ᵢ. Die Sensor-Wandlerspiegelelektrode 45 umfasst jeweils Kammelemente mit einer Mehrzahl von Kammfingern 46. Die Sensor-Wandlerspiegelelektrode 45 ist entsprechend einer Gegenelektrode passend zu den Sensor-Wandlerstatorelektroden 44; ausgebildet. Die Sensor-Wandlerspiegelelektroden 45 können insbesondere entsprechend den Aktuator-Wandlerspiegelelektroden 42, auf deren Beschreibung hiermit verwiesen wird, ausgebildet sein.

Die Sensor-Wandlerspiegelelektroden 45 sind jeweils fix mit dem Spiegelkörper 27 verbunden. Bei einer Verkippung des Einzelspiegels 20 kann die Sensor-Wandlerspiegelelektrode 45 jeweils unterschiedlich tief zwischen die Kammfinger der Sensor-Wandlerstatorelektroden 44ᵢ, insbesondere zwischen die Sender-Elektrode 47 und die Empfänger-Elektrode 48 eintauchen. Hierdurch kommt es zu einer variablen Abschirmung benachbarter Kammfinger, insbesondere zu einer variablen Abschirmung der Empfänger-Elektrode 48 von der Sender-Elektrode 47. Dies führt dazu, dass sich die Kapazität zwischen den benachbarten Kammfingern der Sensor-Wandlerstatorelektroden 44; bei einer Verschwenkung des Einzelspiegels 20 ändert. Die Kapazitätsänderung kann gemessen werden. Hierzu sind die Eingänge eines Messgeräts alternierend mit den Kammfingern der Sensor-Wandlerstatorelektroden 44; verbunden.

Die Eintauchtiefe der Sensor-Wandlerspiegelelektroden 45 zwischen die Sensor-Wandlerstatorelektroden 44ᵢ, insbesondere zwischen die Sender-Elektroden 47 und die Empfänger-Elektroden 48 beträgt in der Neutralposition 30 µm. Die Eintauchtiefe in der Neutralposition kann im Bereich von 20 µm bis 60 µm liegen. Hierdurch wird sichergestellt, dass die Kammfinger 46 auch in der maximal verkippten Verschwenkposition überall noch eine Resteintauchtiefe zwischen die Sender-Elektroden 47 und die Empfänger-Elektroden 48 aufweisen, das heißt nie vollständig austauchen. Hierdurch wird der differenzielle Sensorbetrieb über den vollständigen Verkippungsbereich gewährleistet. Andererseits ist die Eintauchtiefe der Sensor-Wandlerspiegelelektrode 45 derart gewählt, dass es auch in der maximal verkippten Verschwenkposition des Einzelspiegels 20 nicht zu einer Kollision derselben mit dem Substrat 39 kommt.

Zur Messung der Kapazität zwischen der Sender-Elektrode 47 und der Empfänger-Elektrode 48 der Sensor-Wandlerstatorelektroden 44; wird an die Sender-Elektrode 47 eine elektrische Spannung, insbesondere eine Sensor-Spannung Us angelegt. Als Sensor-Spannung Us kann insbesondere eine Wechselspannung dienen.

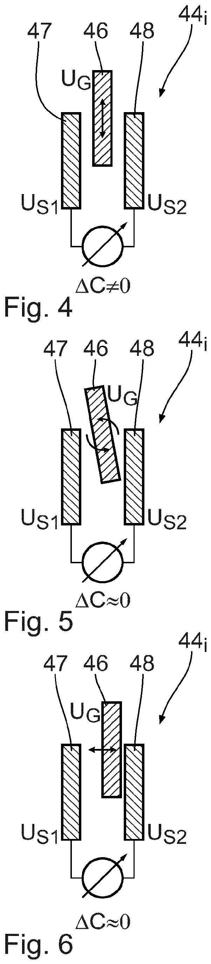

Wie exemplarisch in den Figuren 4 bis 6 dargestellt ist, werden benachbarte Kammfinger der Sensor-Wandlerstatorelektroden 44; alternierend auf unterschiedlichen elektrischen Potenzialen Usi, U_{S2} gehalten. Beispielsweise werden die Sender-Elektroden 47 auf einem Potenzial Usi und die Empfänger-Elektroden 48 auf einem elektrischen Potenzial U_{S2} gehalten.

Die Kammfinger 46 der beweglichen Elektrode 45 werden vorzugsweise alle auf demselben Potenzial, beispielsweise U_{G}, gehalten.

Die Sensor-Einrichtung ist sensitiv im Hinblick auf die Eintauchtiefe der Kammfinger 46 zwischen benachbarten Kammfingern der Sensor-Wandlerstatorelektroden 44; (Fig. 4).

Die Sensor-Einrichtung ist insensitiv gegenüber einer reinen Verschwenkung des Kammfingers 46 relativ zu der Sender-Elektrode 47 und der Empfänger-Elektrode 48 (Fig. 5).

Die Sensor-Einrichtung ist insensitiv gegenüber einer lateralen Verschiebung des Abschirm-Elements, welche den Abstand desselben zur Sender-Elektrode 47 und zur Empfänger-Elektrode 48 ändert, die Eintauchtiefe des Kammfingers 46 zwischen den benachbarten Sender- und Empfänger-Elektroden 47, 48 jedoch unverändert lässt (Fig. 6).

Im Folgenden werden weitere Details die Sensoreinrichtung näher beschrieben.

Die Sensor-Wandlerstatorelektroden 44; sind innerhalb des Rings der Aktuator-Wandler-Statorelektroden 37; angeordnet. In diesem Bereich sind die absoluten Bewegungen der Kammfinger 46 in Richtung parallel zur Flächennormalen 36 geringer als außerhalb des Rings der Aktuator-Wandler-Statorelektroden 37;. Der absolute Bewegungsumfang hängt mit dem Abstand zum effektiven Schwenkpunkt 35 zusammen.

Die Kammfinger der Sensor-Wandlerstatorelektroden 44; sind insbesondere in einem separaten Ring innerhalb des Rings der Aktuator-Wandler-Statorelektroden 37; angeordnet.

Die Kammfinger der Sensor-Wandlerstatorelektroden 44; sind radial relativ zum effektiven Schwenkpunkt 35 ausgebildet und angeordnet. Die Sensor-Wandlerstatorelektroden 44; weisen insbesondere in Radialrichtung verlaufende Kammfinger auf. Hierdurch wird die Sensitivität in Bezug auf eine mögliche thermische Ausdehnung des Einzelspiegels 20 verringert.

Wie bereits vorhergehend erläutert wurde, weist die Sensor-Einrichtung konstruktionsbedingt höchstens eine minimale Sensitivität im Hinblick auf parasitäre Bewegungen des Einzelspiegels 20, insbesondere im Hinblick auf Verlagerungen senkrecht zur Flächennormalen 36 und/oder Rotationen um die Flächennormale 36 auf. Aufgrund des Abschirm-Prinzips der Sensor-Einrichtung weist diese auch höchstens eine minimale Sensitivität im Hinblick auf eine mögliche thermische Ausdehnung des Einzelspiegels 20 auf. Des weiteren weist das Sensorprinzip eine minimale Sensitivität hinsichtlich thermischer Verbiegung des Spiegels auf.

Jeweils zwei einander bezüglich des effektiven Schwenkpunkts 35 gegenüberliegende Sensor-Einheiten mit jeweils mindestens einer Sender-Elektrode 47 und mindestens einer Empfänger-Elektrode 48 sind differenziell verschaltet oder zumindest differenziell auslesbar. Dies ermöglicht es, Störungen der Messung der Position des Spiegels 20, insbesondere aufgrund von Eigenmoden des Einzelspiegels 20, zu eliminieren.

Die aktiven Bestandteile der Sensor-Einrichtung sind auf dem Substrat 39 angeordnet. Dies ermöglicht es, den Kippwinkel des Einzelspiegels 20 direkt relativ zum Substrat 39 zu messen. Außerdem kann aufgrund der Anordnung der Sender-Elektroden 47 und der Empfänger-Elektroden 48 auf dem Substrat 39 die Länge der Signalleitung und/oder der Versorgungsleitungen reduziert, insbesondere minimiert, werden. Hierdurch werden mögliche Störeinflüsse verringert. Hierdurch werden konstante Betriebsbedingungen sichergestellt.

Die Sender-Elektroden 47 können mit einer Wechselspannung von einer Spannungsquelle beaufschlagt werden. Die Spannungsquelle weist eine geringe Impedanz auf. Die Spannungsquelle weist insbesondere eine Ausgangsimpedanz auf, welche im Bereich der Anregungsfrequenz kleiner ist als 1 %o der Kopplungskapazitäten von den Aktuator-Wandlerstatorelektroden 37; zu den Sender-Elektroden 47. Die Ausgangsimpedanz der Spannungsquelle ist kleiner als 1 %o der Kapazitäten zwischen den Sender-Elektroden 47 und den Sensor-Wandlerspiegelelektroden 45 beziehungsweise den Empfänger-Elektroden 48. Hierdurch wird sichergestellt, dass die auf die Senderelektroden 47 aufgeprägte Wechselspannung nicht oder zumindest nicht wesentlich von den variablen Aktuatorspannungen U_{A} oder von der variablen Sensorkapazität beeinflusst wird.

Das Gelenk 32 ist als kardanisches Festkörpergelenk ausgebildet.

Das Gelenk 32 kann insbesondere als Torsionsfederelement-Struktur ausgebildet sein. Es umfasst insbesondere zwei Torsionsfedern 50, 51. Die beiden Torsionsfedern 50, 51 sind einteilig ausgebildet. Sie sind insbesondere senkrecht zueinander ausgerichtet und bilden eine kreuzförmige Struktur 49.

Die Torsionsfedern 50, 51 weisen eine Länge von etwa 100 µm, eine Breite von etwa 60 µm und eine Dicke von etwa 1 µm bis 5 µm auf. Derartige Torsionsfedern 50, 51 eignen sich als Einzelspiegel 20 mit Abmessungen von 0,6 mm · 0,6 mm. Die Abmessungen der Torsionsfedern 50, 51 hängen von den Abmessungen der Einzelspiegel 20 ab. Allgemein benötigen größere Spiegel größere, insbesondere steifere Torsionsfedern 50, 51.

Die Torsionsfeder 50 erstreckt sich in Richtung der Kippachse 33. Die Torsionsfeder 50 ist mechanisch mit dem Substrat 39 verbunden. Zur Verbindung der Torsionsfeder 50 mit dem Substrat 39 dienen Verbindungsblöcke 52. Die Verbindungsblöcke 52 sind jeweils quaderförmig ausgebildet. Sie können auch zylinderförmig, insbesondere kreiszylinderförmig ausgebildet sein. Andere geometrische Formen sind ebenso möglich.

Die Verbindungsblöcke 52 sind jeweils in einem Endbereich der Torsionsfeder 50 angeordnet.

Die Verbindungsblöcke 52 dienen außer der Verbindung des Gelenks 32 mit dem Substrat 39 auch als Distanzstücke zwischen der Torsionsfeder 50 und dem Substrat 39.

Entsprechend der Verbindung der Torsionsfeder 50 mit dem Substrat 39 ist die Torsionsfeder 51 mit dem Spiegelkörper 27 des Einzelspiegels 20 mechanisch verbunden. Hierfür sind Verbindungsblöcke 53 vorgesehen. Die Verbindungsblöcke 53 entsprechen in ihrer Ausbildung den Verbindungsblöcken 52. Die Verbindungsblöcke 53 sind jeweils in einem Endbereich der Torsionsfeder 51 angeordnet.

Das Gelenk 32 kann auch anders ausgebildet sein. Es kann insbesondere anstelle der Torsionsfedem 50, 51 Biegefedern aufweisen.

Die Verbindungsblöcke 53 und die Verbindungsblöcken 52 sind in Richtung der Flächennormalen 36 auf entgegengesetzten Seiten der kreuzförmigen Struktur 49 angeordnet.

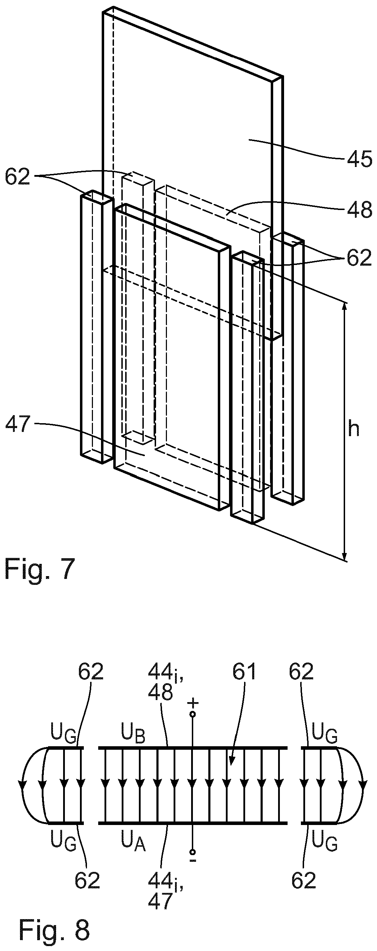

Im Folgenden werden unter Bezugnahme auf die Figuren 7 bis 10 weitere vorteilhafte Aspekte der Sensor-Einrichtung beschrieben.

Es wurde erkannt, dass das elektrische Feld zwischen zwei Kammfingern 47, 48 der Sensor-Wandlerstatorelektroden 44; im Allgemeinen nicht über die gesamte Erstreckung der Kammfinger 47, 48 der Sensor-Wandlerstatorelektroden 44; in Radialrichtung homogen ist. Das elektrische Feld weist insbesondere im Randbereich der Kammfinger 47, 48 Sensor-Wandlerstatorelektroden 44; Inhomogenitäten auf. Dies kann dazu führen, dass eine laterale Verschiebung der Kammfinger 47, 48 der Sensor-Wandlerspiegelelektroden 45 in Radialrichtung zu Messartefakten, insbesondere zu Fehlern bei der Detektion des Verkippungswinkels des Einzelspiegels 20, führen kann.

Zur Verhinderung derartiger Messfehler ist mindestens ein Mittel zur Eingrenzung des für die Messung relevanten elektrischen Feldes 61 auf den Bereich zwischen zwei benachbarten Kammfingern 47, 48 der Sensor-Wandlerstatorelektroden 44; vorgesehen. Es ist insbesondere vorgesehen, den Einfluss von Streufeldern in den Randbereichen der Kammfinger auf die Messung der Verlagerungsposition durch ein derartiges Mittel zu minimieren.

Als Mittel zur Eingrenzung des für die Messung relevanten elektrischen Feldes 61 im Bereich zwischen zwei benachbarten Kammfingern 47, 48 der Sensor-Wandlerstatorelektroden 44; sind insbesondere Abschirmelektroden 62 vorgesehen. Die Abschirmelektroden 62 sind jeweils in Verlängerung zu einem der Kammfinger 47, 48 der Sensor-Wandlerstatorelektroden 44; angeordnet. Sie sind insbesondere jeweils in Radialrichtung außen und innen an den Kammfingern 47, 48 der Sensor-Wandlerstatorelektroden 44; angeordnet. Sie bilden vorzugsweise jeweils eine Verlängerung der Kammfinger 47, 48 der Sensor-Wandlerstatorelektroden 44ᵢ. Sie sind durch einen schmalen Spalt von den Kammfingern 47, 48 der Sensor-Wandlerstatorelektroden 44ᵢ getrennt. Die Breite des Spalts liegt insbesondere im Bereich zwischen 3 µm und 6 µm.

Die Abschirmelektroden 62 weisen in Richtung senkrecht zum Substrat 39 vorzugsweise dieselbe Höhe h auf wie die Kammfinger 47, 48 der Sensor-Wandlerstatorelektroden 44ᵢ beziehungsweise bilden eine Fortsetzung der entsprechenden Außenkontur derselben.

Für jeden der Kammfinger 47, 48 der Sensor-Wandlerstatorelektroden 44i, insbesondere jede der Senderelektroden 47 und jede der Empfängerelektroden 48 sind vorzugsweise zwei Abschirm-Elektroden 62 vorgesehen.

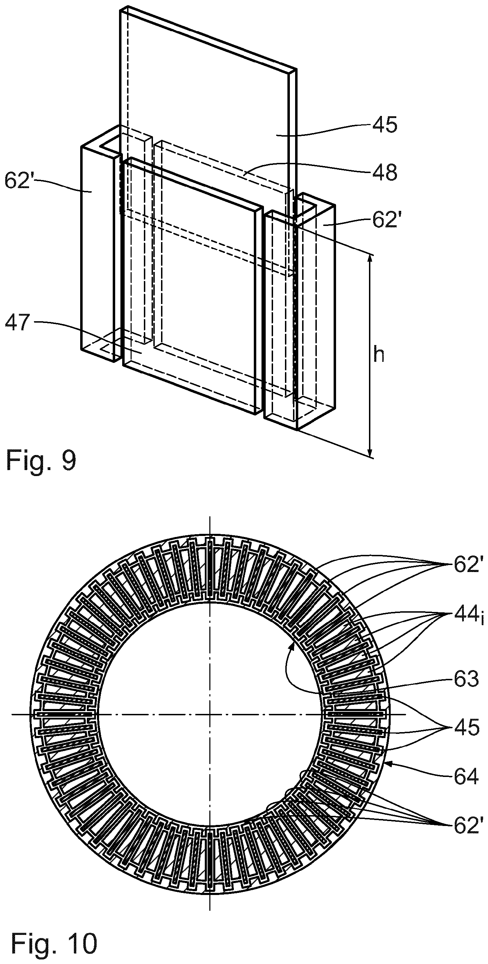

Die Abschirm-Elektroden 62 eines Paares von Senderelektroden 47 und Empfängerelektroden 48 können zu einer einzigen Abschirm-Elektrode 62` miteinander verbunden sein. Eine entsprechende Alternative ist in Figur 9 dargestellt. Die Abschirm-Elektroden 62` weisen somit einen U-förmigen Querschnitt auf.

Es ist auch möglich, sämtliche der Abschirm-Elektroden 62 der Sensor-Einrichtung elektrisch leitend miteinander zu verbinden. Eine entsprechende Alternative ist schematisch in der Figur 10 dargestellt. Bei dieser Alternative sind die Abschirm-Elektroden 62; 62` jeweils in einem inneren Kreis 63 und einem äußeren Kreis 64 elektrisch leitend miteinander verbunden.

Die Abschirm-Elektroden 62; 62` sind vorzugsweise jeweils auf demselben elektrischen Potenzial (U_{G}) gehalten wie die Sensor-Wandlerspiegel-elektroden 45. Dies kann dadurch erreicht werden, dass die Abschirm-Elektroden 62; 62` elektrisch leitend mit den Sensor-Wandlerspiegel-elektroden 45 verbunden sind.

Vorzugsweise sind die Sensor-Wandlerspiegelelektroden 45 derart ausgebildet, dass sie in Radialrichtung eine größere Erstreckung aufweisen als die Sensor-Wandlerstatorelektroden 44ᵢ. Sie sind insbesondere derart ausgebildet, dass sie sich in Radialrichtung über den gesamten Bereich zwischen zwei benachbarten Kammfingern 47, 48 der Sensor-Wandlerstatorelektroden 44; hinaus bis in den Bereich zwischen den Abschirm-Elektroden 62; 62' hinein erstrecken. Hierdurch kann sichergestellt werden, dass die Sensor-Wandlerspiegelelektroden 45 auch bei einer geringfügigen lateralen Verschiebung, insbesondere bei einer Ausdehnung des Einzelspiegels 20 aufgrund einer Erwärmung desselben, den gesamten Bereich des elektrischen Feldes 61 zwischen den benachbarten Kammfingern der Sensor-Wandlerstatorelektroden 44; in Radialrichtung überdecken.

Bei dem in Figur 10 dargestellten Ausführungsbeispiel können die Elektroden der Aktuator-Einrichtung gleichzeitig Elektroden der Sensor-Einrichtung bilden. In diesem Fall bilden die Aktuator-Wandlerstatorelektroden 37; gerade auch die Sensor-Wandlerstatorelektroden 44ᵢ. Die Aktuator-Wandlerspiegelelektroden 42 sind identisch zu den Sensor-Wandlerspiegelelektroden 45. Für weitere Details sei auf die DE 10 2015 204 874 A1 verwiesen.

Die in Figur 10 dargestellte Variante kann jedoch auch als separate Sensor-Einrichtung dienen. Sie kann insbesondere als separate Elektroden-Struktur zusätzlich zur Aktuator-Struktur vorgesehen sein. Sie kann insbesondere im Innenbereich der Aktuator-Einrichtung angeordnet sein. Sie kann insbesondere als separate Ringstruktur ausgebildet sein.

## Patentansprüche

1. Sensor-Einrichtung zur Erfassung einer Verlagerungsposition eines optischen Bauelements (20) mit
1.1. einer Mehrzahl von Statorelektroden (44ᵢ; 47, 48), welche jeweils eine Mehrzahl von Einzelelektroden aufweisen, welche in einem ringförmigen Bereich angeordnet sind und sich jeweils in einer Ebene durch eine Mittelachse dieses Bereichs erstrecken.
1.2. mindestens einer beweglichen Elektrode (45), welche in Abhängigkeit der Verlagerungsposition des optischen Bauelements (20) zu einer variablen Abschirmung eines elektrischen Feldes (61) im Bereich der Statorelektroden (44;; 47, 48) führt, und
1.3. mindestens einem Mittel zur Eingrenzung des für die Messung der Verlagerungsposition des optischen Bauelements (20) relevanten elektrischen Feldes (61) auf den Bereich der Statorelektroden (44;; 47, 48),
1.4. wobei das Mittel zur Eingrenzung des für die Messung der Verlagerungsposition des optischen Bauelements (20) relevanten elektrischen Feldes (61) auf den Bereich der Statorelektroden (44;; 47, 48) Abschirmelektroden (62, 62') umfasst,
1.5. wobei die Abschirmelektroden (62; 62') jeweils in Verlängerung zu einer der Statorelektroden (44;; 47, 48) angeordnet sind, und
1.6. wobei die Abschirmelektroden (62; 62') durch einen Spalt von den Statorelektroden (44;; 47; 48) getrennt sind.

2. Sensor-Einrichtung gemäß Anspruch 1, **dadurch gekennzeichnet, dass** die Statorelektroden (44;; 47, 48) zusammen mit der mindestens einen beweglichen Elektrode (45) kapazitive Kammwandler bilden, mit welchen über eine Kapazitätsmessung die Relativposition der mindestens einen beweglichen Elektrode (45) zu den ortsfesten Statorelektroden (44;; 47, 48) bestimmt werden kann.

3. Sensor-Einrichtung gemäß einem der vorhergehenden Ansprüche, **dadurch gekennzeichnet, dass** der Spalt eine Breite im Bereich von 3 mm bis 6 mm aufweist.

4. Sensor-Einrichtung gemäß einem der Ansprüche 2 bis 3, **dadurch gekennzeichnet, dass** zumindest eine Teilmenge der Abschirmelektroden (62') einen U-förmigen Querschnitt aufweist.

5. Sensor-Einrichtung gemäß einem der vorhergehenden Ansprüche, **dadurch gekennzeichnet, dass** die mindestens eine bewegliche Elektrode (45) in Radialrichtung eine größere Erstreckung aufweist als die Statorelektrode (44;; 47; 48).

6. Sensor-Einrichtung gemäß einem der Ansprüche 3 bis 5, **dadurch gekennzeichnet, dass** sich die mindestens eine bewegliche Elektrode (45) in Radialrichtung über den gesamten Bereich zwischen den Statorelektroden (44;; 47, 48) hinaus bis in den Bereich zwischen zwei in Verlängerung der Statorelektroden (44ᵢ; 47, 48) angeordneten Abschirmelektroden (62, 62') hinein erstreckt.

7. Sensor-Einrichtung gemäß einem der Ansprüche 3 bis 6, **dadurch gekennzeichnet, dass** die Abschirmelektroden (62, 62') jeweils auf demselben elektrischen Potential (U_{G}) wie die mindestens eine bewegliche Elektrode (45) gehalten sind.

8. Sensor-Einrichtung gemäß einem der Ansprüche 3 bis 7, **dadurch gekennzeichnet, dass** zumindest eine Teilmenge der Abschirmelektroden (62, 62') zu einer ringförmigen Struktur elektrisch leitend miteinander verbunden sind.

9. Optisches Bauelement (30) mit einer Sensor-Einrichtung gemäß einem der vorhergehenden Ansprüche.

10. Vielspiegel-Anordnung (19) mit einer Vielzahl optischer Bauelemente (30) gemäß Anspruch 9.

11. Beleuchtungsoptik (4) für eine Projektionsbelichtungsanlage (1) umfassend mindestens eine Vielspiegel-Anordnung (10) gemäß Anspruch 10.

12. Beleuchtungssystem (2) für eine Projektionsbelichtungsanlage (1) umfassend
12.1. eine Beleuchtungsoptik (4) gemäß Anspruch 11 und
12.2. eine Strahlungsquelle (3) zur Erzeugung von Beleuchtungsstrahlung (10).

13. Projektionsbelichtungsanlage (1) für die Mikrolithographie umfassend:
13.1. eine Beleuchtungsoptik (4) gemäß Anspruch 11 und
13.2. eine Projektionsoptik (7) zur Projektion eines in einem Objektfeld (5) der Beleuchtungsoptik (4) angeordneten Retikels auf einen in einem Bildfeld (8) der Projektionsoptik (7) angeordneten Wafer.

14. Verfahren zur Herstellung eines mikro- oder nanostrukturierten Bauelements
14.1. Bereitstellen einer Projektionsbelichtungsanlage (1) nach Anspruch 13,
14.2. Bereitstellen eines Substrats, auf das zumindest teilweise eine Schicht aus einem lichtempfindlichen Material aufgebracht ist,
14.3. Bereitstellen eines Retikels mit abzubildenden Strukturen,
14.4. Projizieren mindestens eines Teils des Retikels auf einen Bereich der lichtempfindlichen Schicht mittels der Projektionsbelichtungsanlage (1),
14.5. Entwickeln der belichteten lichtempfindlichen Schicht.

## Claims

1. Sensor device for measuring a displacement position of an optical component (20), having
1.1 a plurality of stator electrodes (44ᵢ; 47, 48), which each have a plurality of individual electrodes that are arranged in a ring-shaped region and that each extend in a plane through a central axis of this region,
1.2 at least one movable electrode (45), which leads to variable shielding of an electric field (61) in the region of the stator electrodes (44ᵢ; 47, 48) depending on the displacement position of the optical component (20), and
1.3 at least one means for restricting the electric field (61) that is relevant to the measurement of the displacement position of the optical component (20) to the region of the stator electrodes (44ᵢ; 47, 48),
1.4 wherein the means for restricting the electric field (61) that is relevant to the measurement of the displacement position of the optical component (20) to the region of the stator electrodes (44ᵢ; 47, 48) comprises shielding electrodes (62, 62'),
1.5 wherein the shielding electrodes (62, 62') are each arranged along a continuation of one of the stator electrodes (44ᵢ; 47, 48), and
1.6 wherein the shielding electrodes (62, 62') are separated from the stator electrodes (44ᵢ; 47, 48) by a gap.

2. Sensor device according to Claim 1, **characterized in that** the stator electrodes (44ᵢ; 47, 48) and the at least one movable electrode (45) together form capacitive comb transducers, by means of which the relative position of the at least one movable electrode (45) can be determined with respect to the stationary stator electrodes (44ᵢ; 47, 48) by way of a capacitance measurement.

3. Sensor device according to either of the preceding claims, **characterized in that** the gap has a width in the range of 3 mm to 6 mm.

4. Sensor device according to either of Claims 2 and 3, **characterized in that** at least a subset of the shielding electrodes (62') has a U-shaped cross section.

5. Sensor device according to any of the preceding claims, **characterized in that** the at least one movable electrode (45) has a greater extent in the radial direction than the stator electrode (44ᵢ; 47, 48) .

6. Sensor device according to any of Claims 3 to 5, **characterized in that** the at least one movable electrode (45) extends over the entire region between the stator electrodes (44ᵢ; 47, 48) in the radial direction and into the region between two shielding electrodes (62, 62') arranged along the continuation of the stator electrodes (44ᵢ; 47, 48).

7. Sensor device according to any of Claims 3 to 6, **characterized in that** the shielding electrodes (62, 62') are each held at the same electric potential (U_{G}) as the at least one movable electrode (45).

8. Sensor device according to any of Claims 3 to 7, **characterized in that** at least a subset of the shielding electrodes (62, 62') are electrically conductively connected to one another so as to form a ring-shaped structure.

9. Optical component (30) having a sensor device according to any of the preceding claims.

10. Multi-mirror arrangement (19) having a multiplicity of optical components (30) according to Claim 9.

11. Illumination optical unit (4) for a projection exposure apparatus (1) comprising at least one multi-mirror arrangement (19) according to Claim 10.

12. Illumination system (2) for a projection exposure apparatus (1) comprising
12.1 an illumination optical unit (4) according to Claim 11 and
12.2 a radiation source (3) for generating illumination radiation (10).

13. Microlithographic projection exposure apparatus (1) comprising:
13.1 an illumination optical unit (4) according to Claim 11 and
13.2 a projection optical unit (7) for projecting a reticle arranged in an object field (5) of the illumination optical unit (4) onto a wafer arranged in an image field (8) of the projection optical unit (7) .

14. Method for producing a microstructured or nanostructured component, including the following steps:
14.1 providing a projection exposure apparatus (1) according to Claim 13,
14.2 providing a substrate, to which a layer composed of a light-sensitive material is at least partly applied,
14.3 providing a reticle with structures to be imaged,
14.4 projecting at least one part of the reticle onto a region of the light-sensitive layer by means of the projection exposure apparatus (1),
14.5 developing the exposed light-sensitive layer.

## Revendications

1. Dispositif de détection destiné à détecter une position de déplacement d'un composant optique (20), ledit dispositif de détection comprenant
1.1. une pluralité d'électrodes de stator (44ᵢ ; 47, 48) qui chacune comportent chacune une pluralité d'électrodes individuelles qui sont disposées dans une zone annulaire et qui s'étendent chacune dans un plan passant par un axe médian de cette zone,
1.2. au moins une électrode mobile (45) qui, en fonction de la position de déplacement du composant optique (20), conduit à une protection variable d'un champ électrique (61) dans la zone des électrodes de stator (44ᵢ ; 47, 48), et
1.3. au moins un moyen de limitation du champ électrique (61), pertinent pour mesurer la position de déplacement du composant optique (20), à la zone des électrodes de stator (44ᵢ ; 47, 48),
1.4. le moyen de limitation du champ électrique (61), pertinent pour mesurer la position de déplacement du composant optique (20), à la zone des électrodes de stator (44ᵢ ; 47, 48) comprenant des électrodes de blindage (62, 62'),
1.5. les électrodes de blindage (62 ; 62') étant chacune disposées dans le prolongement de l'une des électrodes de stator (44ᵢ ; 47 ; 48), et
1.6. les électrodes de blindage (62 ; 62') étant séparées des électrodes de stator (44 ; 47 ; 48) par un espace.

2. Dispositif de détection selon la revendication 1, **caractérisé en ce que** les électrodes de stator (44ᵢ ; 47, 48) forment avec l'au moins une électrode mobile (45) des transducteurs capacitifs en peigne qui permettent de déterminer la position relative de l'au moins une électrode mobile (45) par rapport aux électrodes de stator fixes (44ᵢ ; 47, 48).

3. Dispositif de détection selon l'une des revendications précédentes, **caractérisé en ce que** l'espace a une largeur dans la gamme allant de 3 mm à 6 mm.

4. Dispositif de détection selon l'une des revendications 2 à 3, **caractérisé en ce qu'**au moins un sous-ensemble des électrodes de blindage (62') a une section transversale en forme de U.

5. Dispositif de détection selon l'une des revendications précédentes, **caractérisé en ce que** l'étendue dans la direction radiale de l'au moins une électrode mobile (45) est supérieure à celle de l'électrode de stator (44ᵢ ; 47 ; 48).

6. Dispositif de détection selon l'une des revendications 3 à 5, **caractérisé en ce que** l'au moins une électrode mobile (45) s'étend dans la direction radiale sur toute la zone comprise entre les électrodes de stator (44ᵢ ; 47, 48) jusque dans la zone comprise entre deux électrodes de blindage (62, 62') disposées dans le prolongement des électrodes de stator (44ᵢ ; 47, 48) .

7. Dispositif de détection selon l'une des revendications 3 à 6, **caractérisé en ce que** les électrodes de blindage (62, 62') sont chacune maintenues au même potentiel électrique (U_{G}) que l'au moins une électrode mobile (45).

8. Dispositif de détection selon l'une des revendications 3 à 7, **caractérisé en ce qu'**au moins un sous-ensemble des électrodes de blindage (62, 62') sont reliées de manière électriquement conductrice les unes aux autres pour former une structure annulaire.

9. Composant optique (30) comprenant un dispositif de détection selon l'une des revendications précédentes.

10. Ensemble multi-miroirs (19) comprenant un grand nombre de composants optiques (30) selon la revendication 9.

11. Optique d'éclairage (4) destiné à un système d'éclairement par projection (1) comprenant au moins un ensemble multi-miroirs (10) selon la revendication 10.

12. Système d'éclairage (2) destiné à un système d'éclairement par projection (1), ledit système d'éclairage comprenant
12.1. une optique d'éclairage (4) selon la revendication 11 et
12.2. une source de rayonnement (3) destinée à générer un rayonnement d'éclairage (10).

13. Système d'éclairement par projection (1) destiné à la microlithographie, ledit système d'éclairement par projection comprenant :
13.1. une optique d'éclairage (4) selon la revendication 11 et
13.2. une optique de projection (7) destinée à projeter un réticule, disposé dans un champ d'objet (5) de l'optique d'éclairage (4), sur une plaquette de silicium disposée dans un champ d'image (8) de l'optique de projection (7).

14. Procédé de fabrication d'un composant micro-structuré ou nano-structuré, ledit procédé comprenant les étapes suivantes
14.1. fournir un système d'éclairement par projection (1) selon la revendication 13,
14.2. fournir un substrat sur lequel une couche d'un matériau photosensible est au moins partiellement appliquée,
14.3. fournir un réticule comprenant des structures à reproduire,
14.4. projeter au moins une partie du réticule sur une zone de la couche photosensible à l'aide du système d'éclairement par projection (1),
14.5. développer la couche photosensible éclairée.
